# EUROPEAN PATENT SPECIFICATION

(11) **EP 2 819 279 B1**
(45) Date of publication and mention of the grant of the patent: **18.01.2017**
(21) Application number: 13173928.6
(22) Date of filing: 27.06.2013
(51) Int. Cl.: H02K 9/04, H05K 7/20

(54) **Cooling apparatus**
Kühlvorrichtung
Systeme de refroidissement

(43) Date of publication of application: 31.12.2014
(73) Proprietor: ABB Research Ltd., 8050 Zürich (CH)
(72) Inventor: Agostini, Francesco, 4800 Zofingen (CH); Torresin, Daniele, 8406 Winterthur (CH); Habert, Mathieu, 4310 Rheinfelden (CH); Agostini, Bruno, 8006 Zürich (CH)
(74) Representative: Kolster Oy Ab

(56) References cited:
- WO-A1-02/093643
- US-A1- 2002 189 789
- US-A1- 2006 216 582
- Anonymous: "Thermal stacking of Power Modules | PowerGuru - Power Electronics Information Portal", , 14 January 2013 (2013-01-14), XP055100325, Retrieved from the Internet: URL:http://www.powerguru.org/thermal-stack ing-of-power-modules/ [retrieved on 2014-02-05]

## Description

### BACKGROUND OF THE INVENTION

### FIELD OF THE INVENTION

This invention relates to an electric apparatus and in particular to a solution for cooling an electric apparatus.

### DESCRIPTION OF PRIOR ART

Previously there is known a solution where a fan arrangement is utilized for providing an air flow via at least two cooling elements, to which electric components are attached, such that the cooling elements receive a heat load produced by the electric components. The air flow passing via the cooling elements receives the heat load from the cooling elements and forwards it to the surroundings. A drawback with the solution described above is that different cooling elements receive a different amount of cooling. The originally relatively cold air passes a first cooling element where the air is heated as it cools the first cooling element. Therefore, subsequent cooling elements in the flow direction of the air will receive air that has been heated by the previous cooling elements. In an implementation involving many cooling elements in series, the temperature of the air flow will rise for each subsequent cooling element that the air flow reaches. This is referred to as thermal stacking. Such a solution is disclosed in "Thermal stacking of Power Modules, PowerGuru Power Electronics Portal", 14 January 2013, for instance.

One common attempt to handle the above described problem of cooling elements operating at different temperatures is to increase the volumetric flow of air. However, this requires a larger fan and increases the pressure drop, energy consumption and noise.

Previously there is also known from US 2006/0216582 A1 and US 2002/0189789 A1 solutions involving two fans generating air flows and two cooling elements. However, each cooling element is cooled by only one airflow.

### SUMMARY OF THE INVENTION

An object of the present invention is to solve the above-mentioned drawback and to provide an electric apparatus with an improved cooling solution. This object is achieved with the electric apparatus according to independent claim 1.

The use of two different air flows with different flow directions makes it possible to ensure that each cooling element and the corresponding electric components receive even and adequate cooling.

### BRIEF DESCRIPTION OF DRAWINGS

In the following the present invention will be described in more detail by way of example and with reference to the attached drawings, in which
Figure 1 illustrates a first embodiment of an apparatus,
Figures 2 and 3 illustrate an embodiment of a cooling element,
Figures 4 and 5 illustrate the temperature behaviour in the first embodiment,
Figure 6 illustrates a second embodiment of an apparatus,
Figure 7 illustrates a third embodiment of an apparatus, and
Figure 8 illustrates a fourth embodiment of an apparatus.

### DESCRIPTION OF AT LEAST ONE EMBODIMENT

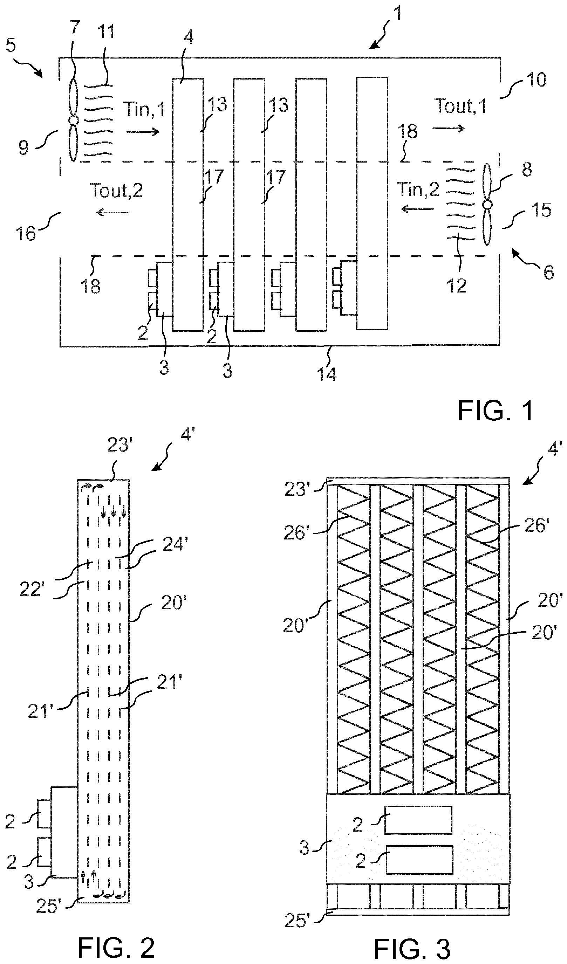

Figure 1 illustrates a first embodiment of an apparatus. The illustrated electric apparatus 1 may be a motor drive providing an electrical motor with electric power, such as a frequency converter for instance.

In the illustrated example the electric components 2 are attached via base plates 3 to cooling elements 4. Base plates are, however, not necessary in all implementations. Heat produced by the electric components during their use is conducted to the cooling elements 4. In the illustrated example, the first ends of the substantially parallel cooling elements 4 are provided with electric components 2, while the opposite, second ends of the cooling elements are arranged in an air flow.

The cooling elements 4 may be manufactured of aluminum or of another suitable material with excellent heat conducting properties, for instance. In their simplest form the cooling elements 4 may consist of heat sinks whose metal material (for instance) conducts heat from the electric components 2 to the air flow. However, as an alternative, it is possible to utilize more sophisticated and efficient cooling elements. Such cooling elements may include an internal fluid circulation, for instance. It is also possible to utilize pulsating heat pipes or two-phase thermosyphons, as illustrated in Figures 2 and 3.

In the example according to Figure 1, the apparatus comprises a first fan arrangement 5 and a second fan arrangement 6 including separately a first fan 7 and a second fan 8. The first fan 7 generates a first air flow from a first inlet 9 to a first outlet 10. This first airflow 11 cools a first part 13 of the cooling elements 4, which in the illustrated example is the uppermost ends of the cooling elements. The first airflow 11 entering the housing or component space 14 via the first inlet 9 has a temperature Tin,1 and the airflow 11 exiting the housing via the first outlet 10 has a temperature Tout,1.

The second fan 8 generates a second air flow 12 from a second inlet 15 to a second outlet 16. The second airflow 12 cools a second part 17 of the cooling elements 4, which in the illustrated example is located in the middle of the cooling elements 4. The second airflow 12 entering the housing or component space 14 via the second inlet 15 is Tin,2 and the airflow 12 exiting the housing or component space 14 via the second outlet 16 is Tout,2.

One or more intermediate walls 18 may extend between the cooling elements 4 to direct the first and second air flows to different parts of the cooling elements 4. Such intermediate walls are not necessary in all embodiments. If intermediate walls are used, tightness is not important but a reasonable amount of leakage may be allowed. The object is, however, to ensure that the first 11 and second 12 air flows, which have different flow directions, do not mix up to an significant extent, but instead the flows occur generally as has been illustrated and explained to cool different parts of the cooling elements. In Figure 1 two intermediate walls 18 have been illustrated by way of example. The intermediate wall 18, which is located lower in Figure 1, prevents the second air flow from reaching the lower ends of the cooling elements 4, where the electric components 2 are located, and the upper intermediate wall 18 keeps the first airflow 11 and second airflow 12 apart from each other.

Though the electric apparatus in Figure 1 is arranged in a housing 14, such a housing is not necessary in all embodiments.

In Figure 1 the cooling elements 4 are arranged in a series configuration with a distance (air gap) between the cooling elements 4 and the respective electric components 2 attached to them. However, as an alternative, the cooling elements in Figure 1 could be arranged in a stacked configuration, where the cooling elements 4 and/or the electric components 2 contact (thermal contact) each other.

As explained above, the flow direction of the second air flow is different than the flow direction of the first air flow. In many implementations, the most efficient solution is to have opposite flow directions. However, exactly opposite flow directions are not necessary in all embodiments, as a sufficiently efficient cooling is also accomplished when the flow directions are different, in other words, not exactly opposite to each other.

Figures 2 and 3 illustrate an embodiment of a cooling element. The cooling element 4' of Figures 2 and 3 is very similar to the cooling elements 4 explained in connection with Figure 1. Therefore, the cooling element of Figures 2 and 3 will mainly be explained by pointing out the differences.

The cooling element 4' of Figures 2 and 3 may be utilized in the electric apparatus of Figure 1. The cooling element 4' is a two-phased thermosyphon with an internal fluid circulation. The cooling element 4' comprises a plurality of pipes 20' arranged side by side, preferably in parallel. Each pipe is divided by internal walls 21' into a plurality of flow channels.

In the illustrated example, the two flow channels located most to the left in Figure 2 are evaporator channels 22' receiving a heat load from the electric components 2 via the base plate 3. Consequently, the fluid evaporates and moves upwards. A manifold 23' in the second upper end of the cooling element returns the fluid via condenser channels 24' to a manifold 25' in a first lower end of the cooling element 4'.

Between the condenser channels 24', fins 26' are arranged in order to transfer heat from the condenser channels 24' to the passing airflow. Therefore, the fluid condensates and returns for a new cycle in the evaporator channels 25'. In order to increase the fluid circulation, some of the channels may have capillary dimensions.

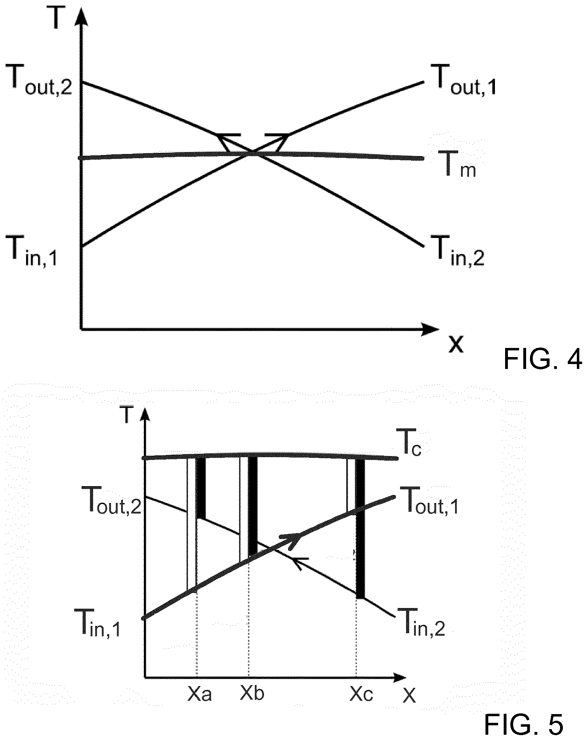

Figures 4 and 5 illustrate the temperature behaviour in the first embodiment of the apparatus as illustrated in Figure 1. In this example, it is by way of example assumed that the flow directions of the first and second air flows are opposite (counter-current flows), as illustrated in Figure 1.

In Figure 4 the temperature T is plotted as a function of the coordinate X across the cooling elements 4 in Figure 1. As can be seen in Figure 4, the temperature Tin,1 of the first air flow 11 is low when the first air flow enters the first inlet 9. After having passed the cooling elements 4, the temperature Tout,1 of the first air flow 11 is much higher, when it exits via the first outlet 10. The second air flow 12 similarly has a low temperature Tin,2 at the second inlet 15 and a much higher temperature Tout,2 at the second outlet 16. The illustrated temperature profile is obtained as both air flows 11 and 12 have the same flow volume and as it is assumed that the power losses for the electric components of all cooling elements are the same.

As can be seen in Figure 4, due to the opposite flow directions, each cooling element 4, irrespective of its location on the flow path of the first and second air flow, will "feel" an average temperature Tm of the surrounding air. Therefore, thermal stacking can be avoided.

Figure 5 illustrates the situation in more detail. The white bars represent the top channel in Figure 1 and the relative temperature evolution, and the black bars represent the bottom channel in Figure 1.

Assuming the same volumetric flow rate and same inlet temperature for both streams, the condenser will "feel" an average operation air temperature Tm as represented in Figure 4, and the condenser will operate at an almost constant saturation temperature represented in the graph of Figure 5 as Tc. To better understand the process, we proceed across the coolers series from left to right and we place ourselves at position Xa. The white and black bars are proportional to the heat exchanged in each subsection (top and bottom one respectively). If now we proceed further across the device starting from Xa, we can identify at each position Xn the heat exchanged by each part of the condenser from the color bars. The total heat exchanged at each point (sum of the heat exchanged by each subsections) is almost constant.

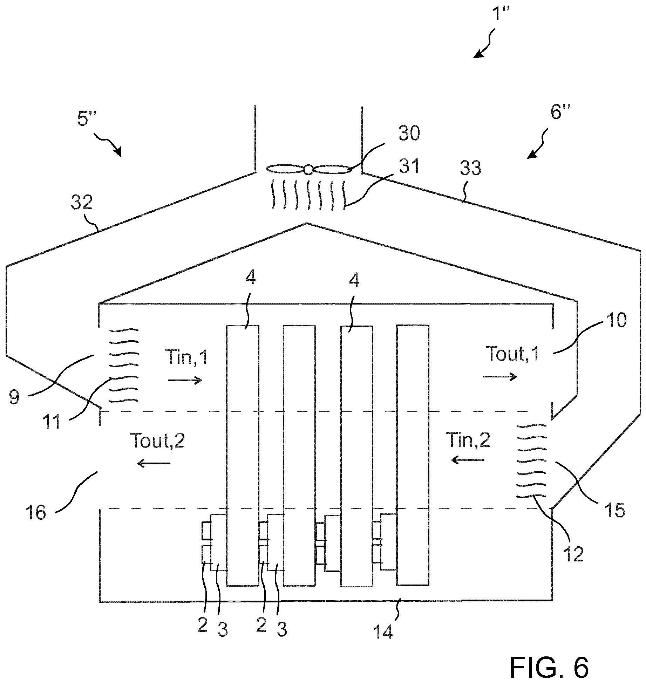

Figure 6 illustrates a second embodiment of an apparatus. The embodiment of Figure 6 is very similar to the one of Figure 1. Therefore, the embodiment of Figure 6 will be explained mainly by pointing out the differences between these embodiments.

In Figure 6 the cooling elements 4 are arranged in a stacked configuration, where the cooling elements 4 with their respective electric components 2 contact (thermal contact) each other. However, this is only by way of example. In practice, it is also possible to utilize the series configuration illustrated in Figure 1 in the embodiment of Figure 6.

In Figure 6 the first 5" and second 6" fan arrangements comprise one single fan 30 only generating one air flow 31. The first 5" and second 6" fan arrangements also comprises a flow channel 32 and 33 splitting the air flow into the first and second air flows 11 and 12 with different flow directions that in the illustrated example are opposite.

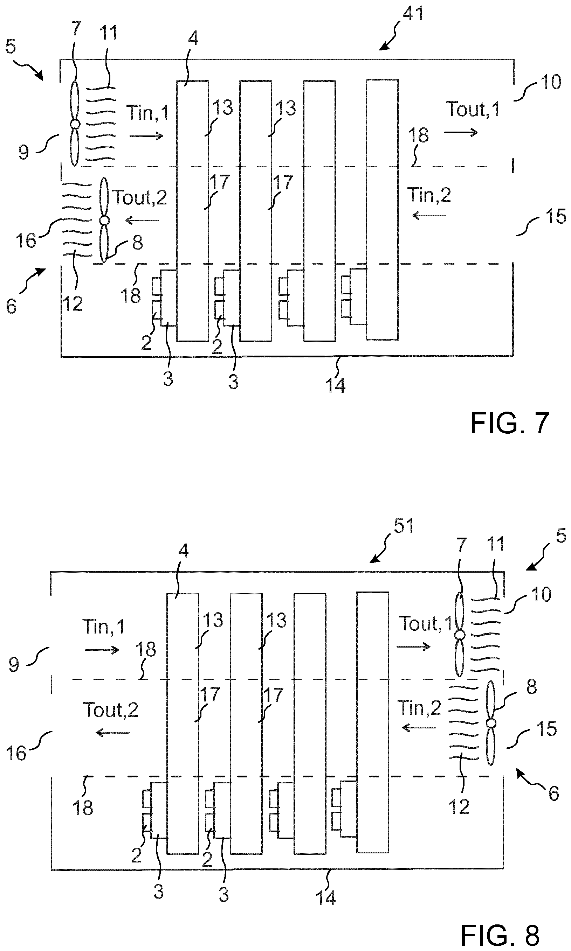

Figure 7 illustrates a third embodiment of an apparatus 41. The embodiment of Figure 7 is similar as the one explained in connection with Figure 1 except for the location of the second fan 8. In the embodiment of Figure 7 the second fan is arranged close to the second outlet 16 where it sucks air through the second inlet 15 and pushes it further through the second outlet.

Figure 8 illustrates a third embodiment of an apparatus 51. The embodiment of Figure 8 is similar as the one explained in connection with Figure 1 except for the location of the first fan 7. In the embodiment of Figure 8 the first fan is arranged close to the first outlet 10 where it sucks air through the first inlet 9 and pushes it further through the first outlet 10.

In the illustrated examples and in the above explanations, two air flows cooling different parts of the same cooling elements are illustrated. However, more than two air streams cooling different parts of the same cooling elements can naturally be utilized. Also in this case the flow directions of the different air flows are advantageously different.

It is to be understood that the above description and the accompanying figures are only intended to illustrate the present invention. It will be obvious to a person skilled in the art that the invention can be varied and modified without departing from the scope of the invention.

## Claims

1. An electric apparatus (1, 1", 41, 51) comprising:
at least two cooling elements (4, 4') for cooling electric components (2) by receiving a heat load produced by the electric components (2), and
a first fan arrangement (5, 5") and a second fan arrangement (6, 6") for generating respective first and second air flows (11, 12) for cooling the at least two cooling elements (4, 4') with a first air flow (11) and a second air flow (12), such that the second fan arrangement (6, 6") creates the second air flow (12) in an opposite flow direction as compared to the first air flow (11) and each of the air flows (11, 12) cools the at least two cooling elements (4, 4'),
wherein
the at least two cooling elements (4, 4') arranged to have the respective electric components (2) attached to them are arranged in a series configuration along the direction of the air flows (11, 12) with an air gap between the at least two cooling elements (4, 4') and the respective electric components (2) when attached to them, and
one or more intermediate walls (18) extend between the at least two cooling elements (4, 4') for directing the first and second air flows (11, 12) to different parts (13, 17) of the at least two cooling elements (4, 4') such that the first (11) and second air flows (12) are arranged to cool different parts (13, 17) of the at least two cooling elements (4, 4').

2. An electric apparatus (1) according to claim 1, wherein the first fan arrangement (5) comprises a first fan (7) and the second fan arrangement (6) comprises a second fan (8).

3. An electric apparatus (1") according to claim 1, wherein the first and second fan arrangements (5", 6") comprise one single fan (30) generating an air flow (31) and a flow channel (32, 33) splitting the air flow (31) into the first and second air flows (11, 12).

4. An electric apparatus (1, 1") according to one of claims 1 to 3, wherein the at least two cooling elements (4, 4') with the respective electric components (2) are arranged in a component space (14) which is surrounded by walls, and the walls are provided with a first and second inlet (9, 15) and with a first and second outlet (10, 16) for passing the first and second air flows (11, 12) through the component space (14).

5. An electric apparatus (1, 1") according to one of claims 1 to 4, wherein the at least two cooling elements (4') are two-phase thermosyphons or pulsating heat pipes.

## Patentansprüche

1. Eine elektrische Vorrichtung (1, 1", 41, 51), aufweisend:
mindestens zwei Kühlelemente (4, 4') zum Kühlen von elektrischen Bauteilen (2) durch Aufnahme einer von den elektrischen Bauteilen (2) erzeugten Wärmebelastung; und
eine erste Ventilatoranordnung (5, 5 ") und eine zweite Ventilatoranordnung (6, 6"), zum Erzeugen jeweiliger erster und zweiter Luftströmungen (11, 12) zum Kühlen der mindestens zwei Kühlelemente (4, 4') mit einem ersten Luftstrom (11) und einem zweiten Luftstrom (12), so dass die zweite Ventilatoranordnung (6, 6 ") den zweiten Luftstrom in einer (12) im Vergleich gegenüber der ersten Luftströmung (11) entgegengesetzten Strömungsrichtung erzeugt und jeder der Luftströmungen (11, 12) die mindestens zwei Kühlelemente (4, 4 ') kühlt,
wobei die mindestens zwei Kühlelemente (4, 4') so angeordnet sind, dass sie die jeweiligen elektrischen Komponenten (2) entlang einer seriellen Ausrichtung entlang der Richtung der Luftströmungen (11, 12) angebracht haben mit einem Luftspalt zwischen den mindestens zwei Kühlelementen (4, 4') und den jeweiligen elektrischen Komponenten (2), wenn sie an diese befestigt sind;
und
eine oder mehrere Zwischenwände (18), welche sich zwischen den mindestens zwei Kühlelementen (4, 4 ') erstrecken zum Ausrichten der ersten und zweiten Luftströmungen (11, 12) auf unterschiedliche Teile (13, 17) der mindestens zwei Kühlelemente (4, 4') derart, dass die erste Luftströmung (11) und dass die zweite Luftströmung (12) angeordnet sind, um verschiedene Teile (13, 17) der mindestens zwei Kühlelemente (4, 4') zu kühlen.

2. Die elektrische Vorrichtung (1) nach Anspruch 1, wobei die erste Ventilatoranordnung (5) einen ersten Ventilator (7) und wobei die zweite Ventilatoranordnung (6) einen zweiten Ventilator (8) aufweist.

3. Die elektrische Vorrichtung (1 ") nach Anspruch 1, wobei die erste Ventilatoranordnung und wobei die zweite Ventilatoranordnung (5", 6") einen einzigen gemeinsamen Lüfter (30) umfassen, um einen Luftstrom (31) zu erzeugen, und ferner einen den Luftstrom (31) in die erste Luftströmung und in die zweite Luftströmung (11, 12) aufteilenden Strömungskanal (32, 33) umfassen.

4. Die elektrische Vorrichtung (1, 1 ") nach einem der Ansprüche 1 bis 3,
wobei die mindestens zwei Kühlelemente (4, 4') mit den jeweiligen elektrischen Komponenten (2) in einem umschlossenen Bauteilraum (14) angeordnet sind, welcher durch Wände umgeben ist, und wobei die Wände mit einem ersten Einlass und einem zweiten Einlass (9, 15) ausgestattet sind und ferner mit einem ersten Auslass und einem zweiten Auslass (10, 16) zum Durchlassen der ersten Luftströmung und der zweiten Luftströmung (11, 12) durch den Bauteilraum (14).

5. Die elektrische Vorrichtung (1, 1 ") nach einem der Ansprüche 1 bis 4,
wobei die mindestens zwei Kühlelemente (4') zweiphasige Thermosyphons oder pulsierenden Wärmerohre sind.

## Revendications

1. Appareil électrique (1, 1", 41, 51) comprenant:
au moins deux éléments de refroidissement (4, 4') pour refroidir des composants électriques (2) en recevant une charge calorifique produite par les composants électriques (2), et
un premier agencement de ventilateur (5, 5") et un second agencement de ventilateur (6, 6") pour générer des premier et second écoulements d'air (11, 12) respectifs pour refroidir les au moins deux éléments de refroidissement (4, 4") avec un premier écoulement d'air (11) et un second écoulement d'air (12), de sorte que le second agencement de ventilateur (6, 6") crée le second écoulement d'air (12) dans une direction d'écoulement opposée par rapport au premier écoulement d'air (11) et que chacun des écoulements d'air (11, 12) refroidit les au moins deux éléments de refroidissement (4, 4'),
dans lequel
les au moins deux éléments de refroidissement (4, 4') agencés pour que les composants électriques (2) respectifs leur soient attachés sont agencés dans une configuration en série le long de la direction des écoulements d'air (11, 12) avec un espace entre les au moins deux éléments de refroidissement (4, 4') et les composants électriques (2) respectifs lorsqu'ils leur sont attachés, et
une ou plusieurs parois intermédiaires (18) s'étendent entre les au moins deux éléments de refroidissement (4, 4') pour diriger les premier et second écoulements d'air (11, 12) vers différentes parties (13, 17) des au moins deux éléments de refroidissement (4, 4'), de sorte que les premier (11) et second écoulements d'air (12) sont agencés pour refroidir différentes parties (13, 17) des au moins deux éléments de refroidissement (4, 4').

2. Appareil électrique (1) selon la revendication 1, dans lequel le premier agencement de ventilateur (5) comprend un premier ventilateur (7) et le second agencement de ventilateur (6) comprend un second ventilateur (8).

3. Appareil électrique (1") selon la revendication 1, dans lequel les premier et second agencements de ventilateur (5", 6") comprennent un seul ventilateur (30) générant un écoulement d'air (31) et un canal d'écoulement (32, 33) divisant l'écoulement d'air (31) en les premier et second écoulements d'air (11, 12).

4. Appareil électrique (1, 1") selon l'une des revendications 1 à 3, dans lequel les au moins deux éléments de refroidissement (4, 4') avec les composants électriques (2) respectifs sont agencés dans un espace de composant (14) qui est entouré par des parois, et les parois sont pourvues de premier et second orifices d'entrée (9, 15) et de premier et second orifices de sortie (10, 16) pour faire passer les premier et second écoulements d'air (11, 12) à travers l'espace de composant (14).

5. Appareil électrique (1, 1") selon l'une des revendications 1 à 4, dans lequel les au moins deux éléments de refroidissement (4') sont des thermosiphons à deux phases ou des caloducs pulsatoires.
